Europäisches Patentamt

European Patent Office

Office européen des brevets

(19)

(11) EP 0 883 172 A1

(12) EUROPEAN PATENT APPLICATION

(43) Date of publication:
09.12.1998 Bulletin 1998/50

(51) Int. Cl.$^6$: H01L 21/768

(21) Application number: 97108938.8

(22) Date of filing: 03.06.1997

(84) Designated Contracting States:
AT BE CH DE DK ES FI FR GB GR IE IT LI LU MC NL PT SE
Designated Extension States:
AL LT LV RO SI

(71) Applicant: NEC CORPORATION
Tokyo (JP)

(72) Inventor: Ichikawa, Masashi
Minato-ku, Tokyo (JP)

(74) Representative:
Glawe, Delfs, Moll & Partner
Patentanwälte
Postfach 26 01 62
80058 München (DE)

(54) **Method for manufacturing contact structure having titanium/titanium nitride barrier layer**

(57) In a method for manufacturing a contact structure, an aluminum layer (3) is formed over a semiconductor substrate (1). Then, an insulating layer (4) is formed on the aluminum layer, and a throughhole (TH) is perforated in the insulating layer. Then, a titanium layer (5) and a titanium nitride layer (6) are formed in the throughhole. Then, an in situ nitriding operation is performed upon the titanium nitride layer and the titanium layer. Finally, a tungsten layer is formed in the throughhole after the in situ nitriding operation is performed.

Fig. 3C

EP 0 883 172 A1

Printed by Xerox (UK) Business Services
2.16.6/3.4

## Description

## BACKGROUND OF THE INVENTION

### Field of the Invention

The present invention relates to a method for manufacturing a contact structure made by a tungsten (W) plug with a titanium (Ti)/titanium nitride (TiN) barrier layer.

### Description of the Related Art

Generally, in a prior art semiconductor device, an upper metal layer is connected by a contact structure formed in a throughhole in an insulating layer to a lower metal layer. The contact structure (plug) is made of W by a blanket W chemical vapor deposition (CVD) process. Also, a barrier layer made of Ti/TiN is inserted between the W plug and the lower metal layer. In this case, the Ti layer has good step coverage characteristics for the throughhole, and the TiN layer has good contact characteristics for contact to the W plug (see JP-A-4-130720).

In the prior art method, if the lower metal layer is made of aluminum (Al), it is impossible to form the TiN layer by performing a ramp annealing operation upon the Ti layer under a nitrogen gas atmosphere at about 700°C for about 30 seconds, since the lower metal (Al) layer is melted by such a ramp annealing operation. As a result, the TiN layer is deposited by a sputtering process, so that the TiN layer has bad step coverage characteristics for the throughhole. Therefore, the TiN layer may be very thin at the bottom of the throughhole. As a result, during a step for depositing the W plug on the TiN layer, a gas of $WF_6$ is reacted with the Ti layer by

$$WF_6 + Ti \rightarrow TiW_x + F$$

Thus, the Ti layer is etched by $WF_6$ at the bottom of the throughhole, so that no barrier layer is present between the lower metal (Al) layer and the W plug. In this case, the aluminum component of the lower metal (Al) layer is reacted with $WF_6$ to produce AlF, which increases the resistance of the contact structure. This will be explained later in detail.

## SUMMARY OF THE INVENTION

It is an object of the present invention to suppress the increase of resistance of a contact structure.

According to the present invention, in a method for manufacturing a contact structure, an aluminum layer is formed over a semiconductor substrate. Then, an insulating layer is formed on the aluminum layer and a throughhole is perforated in the insulating layer. Then, a Ti layer and a TiN layer are formed in the throughhole. Then, an in situ nitriding operation is performed upon the TiN layer and the Ti layer. Finally, a W layer is formed in the throughhole after the in situ nitriding operation is performed.

## BRIBF DESCRIPTION OF THE DRAWINGS

The present invention will be more clearly understood from the description as set forth below as compared with the prior art with roference to the accompanying drawings, wherein:

Figs. 1A through 1E are cross-sectional views for explaining a prior art method for manufacturing a contact structure;
Figs. 2A and 2B are cross-sectional views for explaining a problem in the prior art method as illustrated in Figs. 1A through 1E;
Figs. 3A through 3C are cross-sectional views for explaining an embodiment of the method for manufacturing a contact structure according to the present invention; and
Fig. 4 is a plan view illustrating a CVD apparatus used for carrying out the method according to the present invention.

## DESCRIPTION OF THE PREFERRED EMBODIMENT

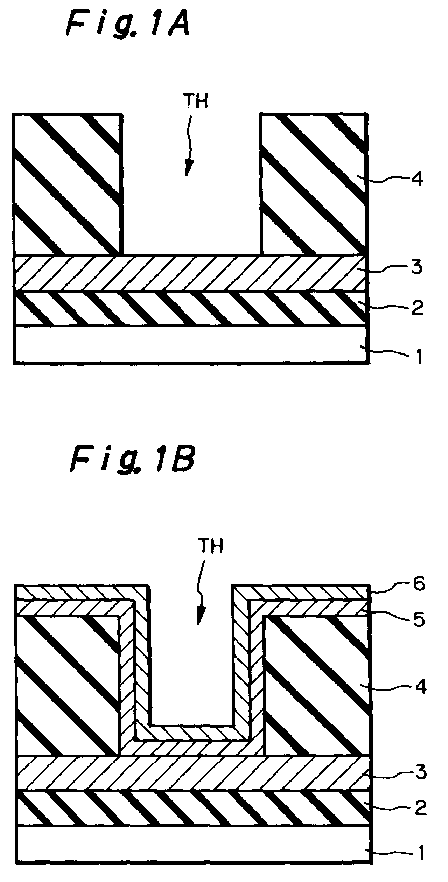

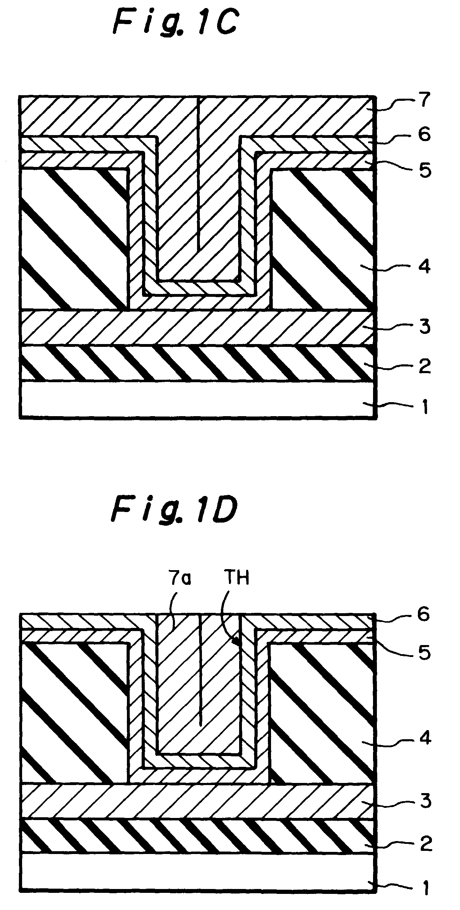

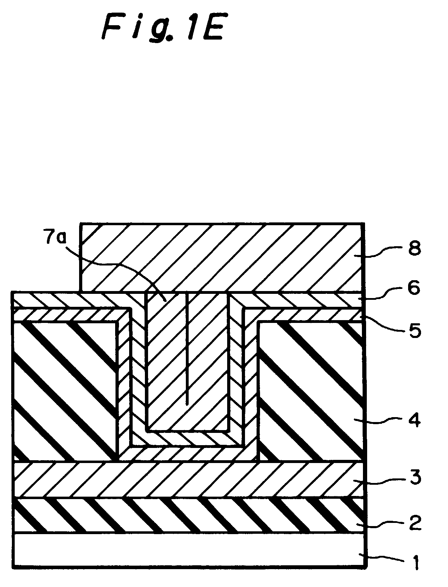

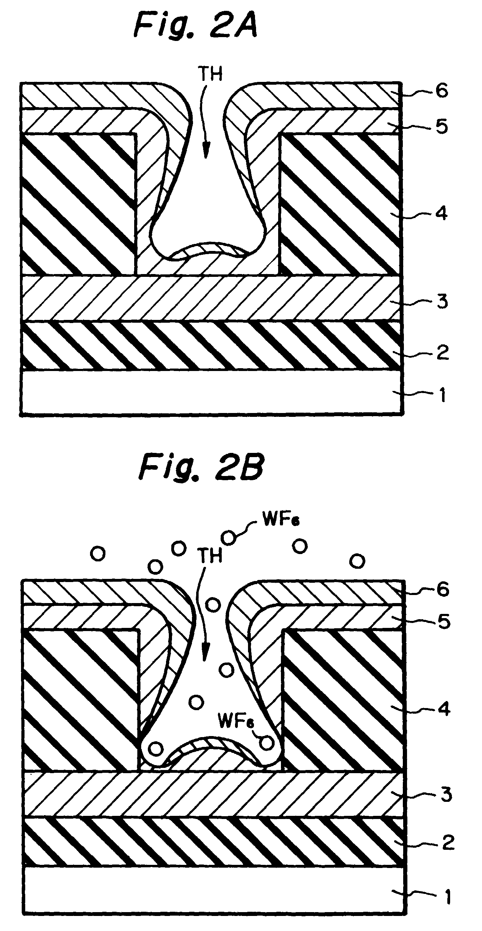

Before the description of the preferred embodiment, a prior art method for manufacturing a semiconductor device will be explained with reference to Figs. 1A, 1B, 1C, 1D, 1E, 2A and 2B.

First, referring to Fig. 1A, a silicon oxide layer 2 is formed by a thermal oxidation process or a CVD process on a monocrystalline silicon substrate 1. Then, an Al (or its alloy) layer 3 is deposited by a sputtering process on the silicon oxide layer 2.

Then, a boron-included phospho-silicated glass (BPSG) layer 4 is formed by a CVD process, and a throughhole TH is perforated in the BPSG layer 4 by a photolithography and etching process.

Next, referring to Fig. 1B, a Ti layer 5 is deposited on the BPSG layer 4. Then, a TiN layer 6 is deposited on the Ti layer 5.

The Ti layer 5 and the TiN layer 6 serve as a barrier layer between the Al layer 3 and a W layer 7 which will be later formed (see Fig. 1C). In this case, the Ti layer 5 has good step coverage characteristics for the throughhole TH, and the TiN layer 6 has good contact characteristics for contact to the W layer 7. Also, it is impossible to form the TiN layer 6 by performing a ramp annealing operation upon the Ti layer 5 a under a nitrogen gas atmosphere at about 700°C for about 30 seconds, since the Al layer 3 is melted by such a ramp annealing operation.

Next, referring to Fig. 1C, a W layer 7 is deposited on the TiN layer 6 by a blanket W CVD process.

Next, referring to Fig. 1D, the W layer 7 is etched back by a plasma etching process, so that a W plug 7a is buried in the throughhole TH.

Finally, referring to Fig. 1E, an aluminum (or its alloy) layer 8 is deposited by a sputtering process, and is patterned.

In the above-described prior art method, however, since the TiN layer 6 is deposited by a sputtering process, the TiN layer 6 has bad step coverage characteristics for the throughhole TH. Therefore, as illustrated in Fig. 2A, which corresponds to Fig. 1B, the TiN layer 6 may be very thin at the bottom of the throughhole TH. As a result, as illustrated in Fig. 2B, during a step for depositing the W layer 7 on the TiN layer 6, a gas of $WF_6$ is reacted with the Ti layer 5 by

$$WF_6 + Ti \rightarrow TiW_x + F$$

Thus, the Ti layer 5 is etched by $WF_6$ at the bottom of the throughhole TH, so that no barrier layer is present between the Al layer 3 and the W layer 7. In this case, the aluminum component of the Al layer 3 is reacted with $WF_6$ to produce AlF, which increases the resistance of the contact structure.

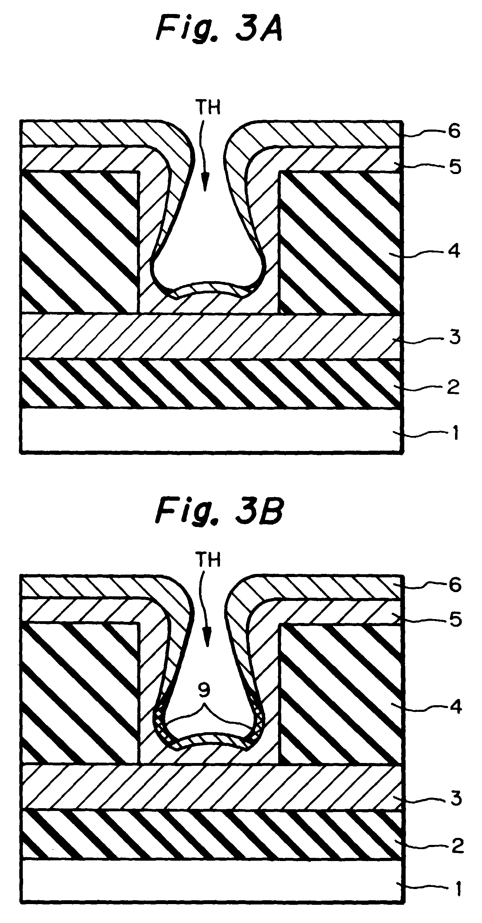

Figs. 3A through 3C as well as Figs. 1A through 1E illustrate an embodiment of the method for manufacturing a semiconductor device according to the present invention. That is, a step for forming an in situ TiN layer 9 is carried out after the step for forming the Ti layer 5 and the TiN layer 6 as illustrated in Fig. 1B and before the step for forming the W layer 7 as illustrated in Fig. 1C.

In more detail, referring to Fig. 3A, after the step for forming the Ti layer 5 and the TiN layer 6, it is assumed that the TiN layer 6 is very thin at the bottom of the throughhole TH, so that a part of the Ti layer 5 is exposed.

Next, referring to Fig. 3B, an in situ nitriding operation is carried out, so that an in situ TiN layer 9 is formed by using the same sputtering apparatus for forning the W layer 7 which will be explained later in detail.

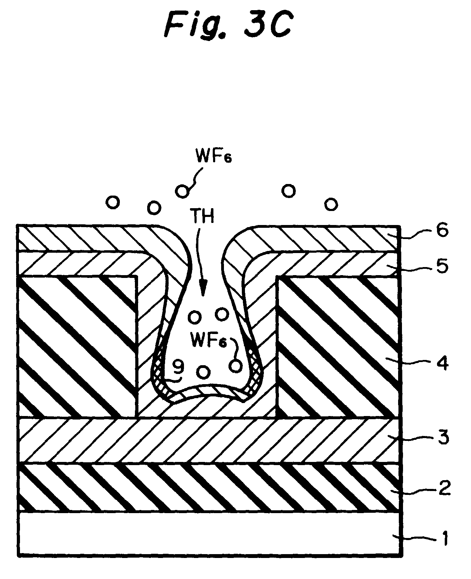

Next, referring to Fig. 3C, even when $WF_6$ is supplied to the device during a step for forming the W layer 7, $WF_6$ cannot reach the Ti layer 5 due to the presence of the in situ TiN layer 9 and the TiN layer 6 therebetween. Thus, the Ti layer 5 is hardly etched by $WF_6$ at the bottom of the throughhole TH, so that the aluminum component of the Al layer 3 is hardly reacted with $WF_6$, which suppresses the increase of resistance of the contact structure.

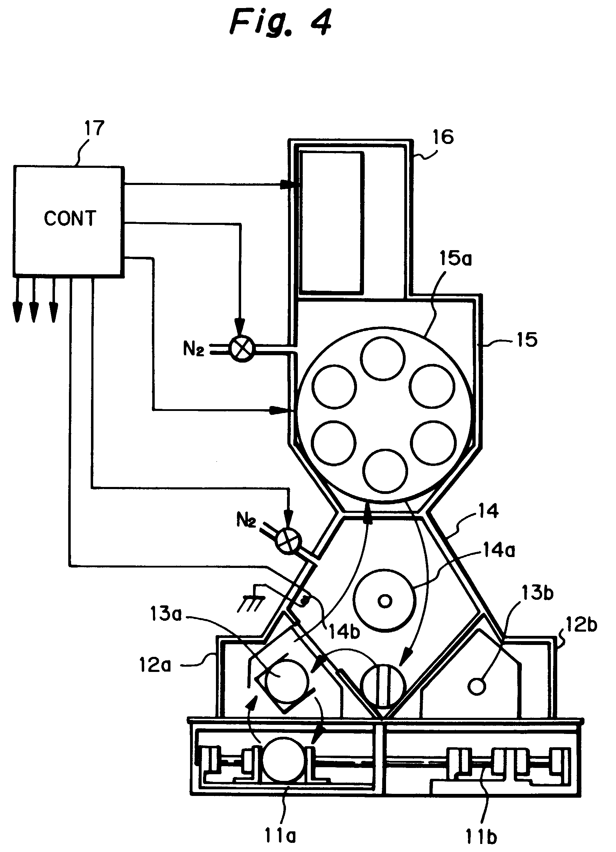

An in situ TiN layer forming step is explained next with reference to Fig. 4 which is a plan view illustrating a CVD apparatus.

In Fig. 4, reference numerals 11a and 11b designate shuttles for taking wafers into load lock chambers 12a and 12b, respectively, and taking wafers from the load lock chambers 12a and 12b, respectively. The load lock chambers 12a and 12b include index robots 13a and 13b, respectively. The load lock chambers 12a and 12b are next to a carrier chamber 14 including a carrier robot 14a. The carrier chamber 14 is next to a reaction chamber 15 inclnding a wafer holder 15a. The reaction chamber 15 is next to a reaction mechanism 16 for supplying reaction gas such as $SiH_4$, $WF_6$, $H_2$ and the like to the reaction chamber 15.

In Fig. 4, $N_2$ gas can be supplied to the carrier chamber 14, the reaction chamber 15 and the like. Also, the wafer holder 15a incorporates a heater (not shown), and the carrier chamber 14 has a heater 14b.

The entire apparatus of Fig. 4 is controlled by a control circuit 17 which is constructed by a microcomputer.

The in situ TiN layer forming step of the present invention carried out by using the CVD apparatus of Fig. 4 is explained next.

First, a set of wafers having the Ti layer 5 and the TiN layer 6 are taken from one of the shuttles such as 11a into the load lock chamber 12a by the index robot 13a. Then, the load lock chamber 12a is evacuated to create a vacuum. Then, the wafers are moved from the load lock chamber 12a to the carrier chamber 14 by the carrier robot 14a, and are further moved from the carrier chamber 14 to the wafer holder 15a of the reaction chamber 15 by the carrier robot 14a.

In the reaction chamber 16, the wafers are heated by the heater of the wafer holder 15a to about 450°C, and $N_2$ gas is introduced into the reaction chamber 15. Thus, an in situ TiN layer is formed on an exposed portion of the Ti layer 5 as illustrated in Figs. 3A and 3B.

After the in situ TiN layer forming operation, the W layer 7 is formed by a blanket W CVD process. That is, first, a gas of $SiH_4$ is introduced from the reaction mechanism 16 into the reaction chamber 15 for about 30 seconds. Thus, fluorine absorbed onto the wafers is removed, and $SiH_4$, which is a reducing agent of $WF_6$, is absorbed in the wafers to improve the uniformity of the W layer 7. In addition, the penetration of $WF_6$ into the wafers can be avoided. In this case, nucleuses of Si are formed on the surface of the TiN layer 6 and the in situ TiN layer 9.

Next, a gas of $WF_6$ as well as the gas of $SiH_4$ are introduced from the reaction mechanism 10 into the reaction chamber 15. As a result, $WF_6$ gas is reacted with $SiH_4$ gas, so that nucleuses of W are formed on the nucleuses of Si.

Finally, a gas of $H_2$ instead of $SiH_4$ is introduced from the reaction mechanism 16 into the reaction chamber 15. As a result, $WF_6$ gas is reacted with $H_2$ gas, so that W is deposited on the entire surface.

Then, in the same way as in the prior art, the W layer 7 is etched backed, so that the W plug 7a is buried in the throughhole TH. However, after the nucleuses of W are formed, they can be etched back so as to remain in the throughhole TH, and thereafter, W can be deposited only on the nucleuses of W in the throughhole TH.

In addition, the in situ TiN layer 9 can be formed in the carrier chamber 14. That is, when the wafers are located in the carrier chamber 14 before moving to the reaction chamber 15, the wafers are heated by the heater in the carrier chamber 14 to about 450°C, and $N_2$ gas is introduced into the carrier chamber 14. Thus, an in situ TiN layer is also formed on an exposed portion of the Ti layer 5 as illustrated in Figs. 3A and 3B.

Further, it is possible to form an in situ TiN layer in the load lock chambers 12a and 12b.

The formation of an in situ TiN layer in the carrier chamber 14 or the load lock chambers 12a and 12b improves the throughput.

As explained hereinabove, according to the present invention, since a Ti layer at the bottom of a throughhole is completely covered by a TiN layer including an in situ TiN layer, during a step for depositing a W layer on the TiN layer, a gas of $WF_6$ is hardly reacted with the Ti layer. Thus, the Ti layer is hardly etched by $WF_6$ at the bottom of the throughhole, so that the aluminum component of an underlying Al layer is hardly reacted with $WF_6$, which can suppress the increase of resistance of a contact structure.

**Claims**

1. A method for manufacturing a contact structure, comprising:

   forming an aluminum layer (3) over a semiconductor substrate (1);
   forming an insulating layer (4) on said aluminum layer;
   perforating a throughhole (TH) in said insulating layer;
   forming a titanium layer (5) in said throughhole;
   forming a titanium nitride layer (6) on said titanium layer;
   performing an in situ nitriding operation upon said titanium nitride layer and said titanium layer;
   forming a tungsten layer (7) in said throughhole after said in situ nitriding layer is performed.

2. The method as set forth in claim 1, wherein said titanium layer forming step and said titanium nitride layer forming step use sputtering processes.

3. The method as set forth in claim 1, wherein said in situ nitriding operation is performed by a chemical vapor deposition apparatus for forming said tungsten layer.

4. A semiconductor device comprising:

   a semiconductor substrate (1);
   an aluminum layer (3) formed over said semiconductor substrate;
   an insulating layer (4) formed on said aluminum layer having a throughhole (TH) for exposing said aluminum layer;

a titanium layer (5) formed on said insulating layer in said throughhole;
a titanium nitride layer (6) formed on said titanium layer;
an in situ titanium nitride layer (9) on a part of said titanium layer in which said titanium nitride layer is not formed; and
a tungsten plug (7a) formed on said titanium nitride layer and said in site titanium nitride layer within said throughhole.

5. The method as set forth in claim 4, wherein said titanium layer and said titanium nitride layer are formed by use sputtering processes.

6. The method as set forth in claim 4, wherein said in situ nitriding operation is performed by a chemical vapor deposition apparatus for forming said tungsten layer.

# Fig. 1A

TH

4

3

2

1

# Fig. 1B

TH

6

5

4

3

2

1

# Fig. 1C

# Fig. 1D

# Fig. 1E

## Fig. 2A

## Fig. 2B

## Fig. 3A

## Fig. 3B

# Fig. 3C

# Fig. 4

European Patent
Office

**EUROPEAN SEARCH REPORT**

Application Number

EP 97 10 8938

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | US 5 591 672 A (LEE CHING-YING ET AL) * column 2, line 57 - column 5, line 25 * --- | 1,2,4,5 | H01L21/768 |
| A | US 5 202 579 A (FUJII HIROYUKI ET AL) * column 7, line 12 - column 9, line 28 * --- | 1,2,4,5 | |
| A | EP 0 720 214 A (APPLIED MATERIALS INC ;AT & T CORP (US)) ----- | | |

TECHNICAL FIELDS
SEARCHED      (Int.Cl.6)

H01L

The present search report has been drawn up for all claims

| Place of search | Date of completion of the search | Examiner |
|---|---|---|
| THE HAGUE | 24 October 1997 | Schuermans, N |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)